Europäisches Patentamt

(19) European Patent Office

Office européen des brevets

(11) Numéro de publication: **0 119 553**
**B2**

(12) **NOUVEAU FASCICULE DE BREVET EUROPEEN**

(45) Date de publication du nouveau fascicule du brevet: **20.06.90**

(21) Numéro de dépôt: **84102478.9**

(22) Date de dépôt: **08.03.84**

(51) Int. Cl.⁵: **H 01 L 39/24, H 01 L 39/14**

(54) **Procédé de fabrication de supraconducteurs.**

(30) Priorité: **16.03.83 FR 8304284**

(43) Date de publication de la demande:
**26.09.84 Bulletin 84/39**

(45) Mention de la délivrance du brevet:
**02.09.87 Bulletin 87/36**

(45) Mention de la decision concernant l'opposition:
**20.06.90 Bulletin 90/25**

(84) Etats contractants désignés:
**CH DE FR GB IT LI NL**

(56) Documents cités:
**DE-A-2 525 980**
**FR-A-2 165 660**
**FR-A-2 305 830**
**US-A-3 489 604**
**US-A-3 618 205**
**US-A-3 963 425**

(73) Titulaire: **ALSTHOM**
**38, avenue Kléber**
**F-75784 Paris Cédex 16 (FR)**

(72) Inventeur: **Dubots, Patrick**
**1, Chemin de Gaillarbois**
**F-78640 Neauphle le Chateau (FR)**

(74) Mandataire: **Weinmiller, Jürgen et al**
**Lennéstrasse 9 Postfach 24**
**D-8133 Feldafing (DE)**

EP 0 119 553 B2

**Description**

La présente invention concerne une procédé de fabrication de supraconducteurs.

Il est connu d'après le brevet FR—A—2 165 660 de fabriquer des supraconducteurs selon les étapes indiquées dans les premières parties des revendications 1 et 2. Les supraconducteurs connus en alliage de niobium et d'étain sont obtenus par diffusion de l'étain d'un bronze dans le niobium à une température de 800°C environ et sont isolés électriquement (les éléments supraconducteurs) par du carbone ou de l'oxyde de magnésium qui ont la propriété de ne pas être solubles dans les métaux lors du traitement thermique considéré. Dans le procédé connu, comme il est décrit dans le brevet en page 4 ligne 28, le brin multifilamentaire est passé dans un bain d'hydroxyde de magnésium, au diamètre final juste avant le traitement thermique de diffusion. Il en découle que les éléments supraconducteurs sont traités lorsqu'ils sont de faible diamètre et de très grande longueur. L'inconvénient de ce procédé réside dans le fait qu'il faut appliquer l'isolant sur une très grande longueur ce qui ne peut être réalisé qu'en embodinant les éléments supraconducteurs puis en les dévidant (page 5, ligne 3) pour les envider ensuite pour la confection d'un électroaimant. Il est à remarquer que les supraconducteurs niobium -étain (Nb3Sn) sont cassants une fois la diffusion réalisée et que le dévidage et les envidages en spires son difficiles à réaliser sans provoquer de cassures entraînant une impossibilité de fonctionnement des supraconducteurs.

Le procédé selon la présente invention remédie à cet inconvénient. Dans celui-ci en effet la mise en place de l'isolant électrique est réalisée sur une petite longueur ce qui en facilite la fabrication et en assure la fiabilité.

La présente invention a pour objet un procédé de fabrication de supraconducteurs comportant dans l'ordre les étapes de fabrication suivantes:

première étape — mise en place en barreaux d'un premier élément métallique dans une matrice métallique à au moins deux deuxièmes éléments, ledit premier élément et un deuxième élément devant former le supraconducteur,

deuxième étape — filage et étirage des barreaux afin d'obtenir des tiges de forme extérieure hexagonale,

troisième étape — empilement des tiges de forme hexagonale en un ensemble et revêtement de cet ensemble par un tube de bronze; la deuxième et la troisième étapes pouvant être répétées une ou deux fois; le tube pouvant être la dernière fois en cuivre et/ou certaines des tiges pouvant être remplacées par des tiges de cuivre, au centre de l'empilement, le tube et les tiges de cuivre servant à la stabilisation.

quatrième étape — filage et étirages multiples successifs de l'ensemble afin de réduire les sections et allonger les longueurs de cet ensemble pour réaliser un brin de faible diamétre,

cinquième étape — embobinage du brin en une bobine,

sixième étape — chauffage de la bobine à une température de 800°C environ pour réaliser la diffusion du premier élément métallique dans le deuxième élément, formant ainsi un composé intermétallique et supraconducteur, caractérisé en ce qu'à la fin de la troisième étape on dispose entre le tube et une couronne résistive une poudre isolante électriquement, réfractaire et non soluble dans les tubes et la couronne, et en ce qu'on cours de la troisième étape et au début de celle-ci, les tiges de forme hexagonale peuvent être empilées les unes contre les autres en même temps qu'une poudre d'oxyde dopé d'élément conducteur disposée entre les empilements et servant de barrières résistives.

La présente invention a également pour objet un procédé de fabrication de supraconductuers comportant dans l'ordre les étapes de fabrication suivantes:

première étape — mise en place en barreaux d'une premier élément métallique dans une matrice métallique à au moins deux deuxièmes éléments, le premier élément et un deuxième élément devant former le supraconducteur,

deuxième étape — filage et étirage des barreaux afin d'obtenir des tiges de forme extérieure hexagonale,

troisième étape — empilement des tiges de forme hexagonale en un ensemble et revêtement de cet ensemble par un tube de cuivre certaines desdites tiges pouvant être remplacées par des tiges de cuivre servant à la stabilisation,

quatrième étape — filage et étirages multiples successifs de cet ensemble afin de réduire les sections et allonger les longueurs de l'ensemble pour réaliser un brin de faible diamétre,

cinquième étape — enrobage des brins multifilamentaires par une gaine résistive, et mise en place d'une pluralité de brins afin de former un conducteur multibrins, formant ainsi un composé intermétallique et supraconducteur,

sixième étape — embobinage du conducteur multibrins en une bobine,

septième étape — chauffage de la bobine à une température de 800°C environ pour réaliser la diffusion du premier élément métallique dans ledit deuxième élément,

caractérisé en ce qu'au cours de la cinquième étape on dispose entre les brins et la gaine résistive une poudre isolante électriquement, réfractaire et non soluble dans ladite gaine résistive et les brins, et en ce qu'au cours de la troisième étape et au début de celle-ci, les tiges de forme hexagonale peuvent être empilées les unes contre les autres en même temps qu'une poudre d'oxyde dopé d'élément conducteur disposée entre les empilements et servant de barrières résistives.

Selon un mode particulier de réalisation de l'invention, les poudres d'oxyde dopé et isolante électriquement peuvent être avantageusement précompactées dans un moule (par exemple sous une pression de quelques dizaines de kg/mm²).

Selon un mode particulier de réalisation de l'invention, la poudre d'oxyde est de l'oxyde de magnésium MgO dopé de cuivre ou d'une alliage de cuivre tel que le bronze ou le cupro-nickel.

Selon un autre mode particulier de réalisation de l'invention, la poudre isolante est de l'oxyde de magnésium MgO ou d'aluminium $Al_2O_3$.

En se référant aux figures schématiques 1 à 3 ci-jointes, on va décrire ci-après des exemples de mise en oeuvre de la présente invention exemples donnés à titre purement illustratif. Les mêmes él'éments représentés sur plusieurs de ces figures portent sur toutes celles-ci les mêmes références.

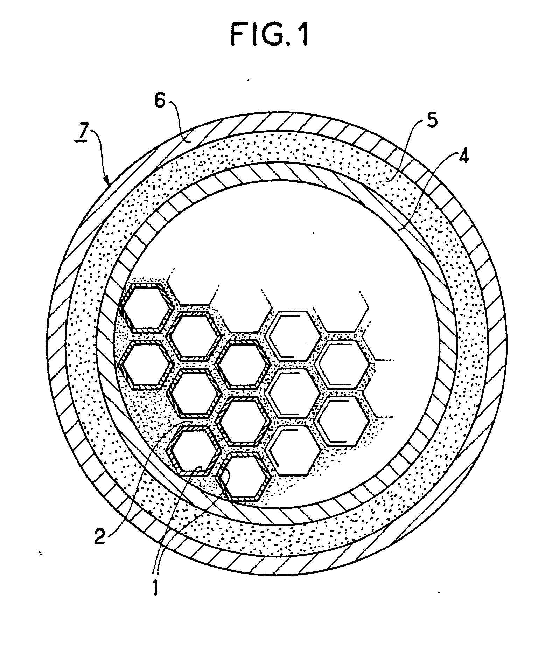

La figure 1 représente une vue en coupe transversale schématique à échelle agrandie à une étape de sa fabrication d'un ensemble 7 de tiges multifilamentaires hexagonales 1 séparées par une poudre d'oxyde dopé d'éléments conducteurs 2, l'ensemble étant recouvert d'un tube de cuivre 4 et d'une couronne résistive 6, entre lesquels est disposée une poudre isolante 5.

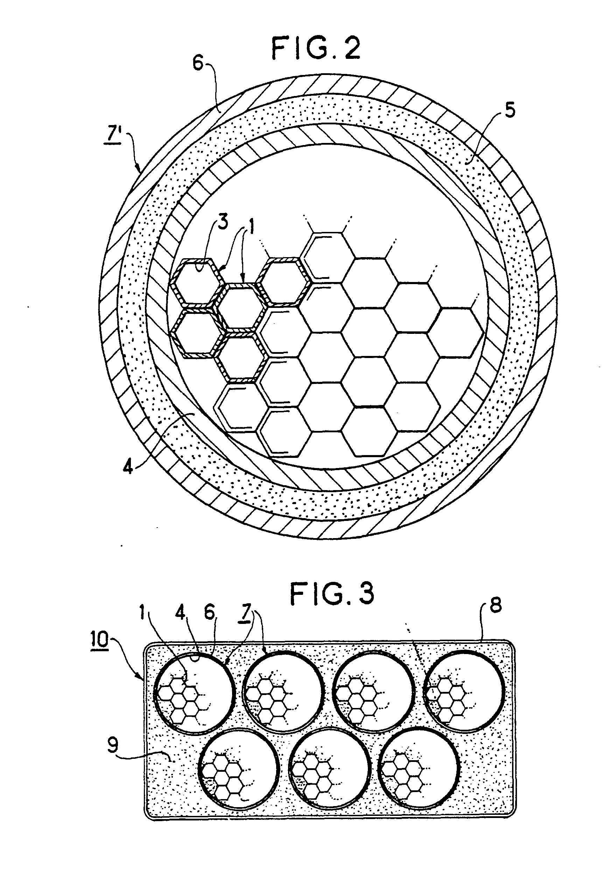

La figure 2 représente une vue en coupe transversale schématique a échelle agrandie à une étape de sa fabrication d'une variante 7' d'un ensemble de tiges multifilamentaires hexagonals à barrièrs résistives 3 en cupro-nickel, recouvert d'un tube de cuivre 4 et d'une couronne résistive 6 entre lesquels est disposée une poudre isolante 5.

La figure 3 représente une vue schématique à échelle très agrandie, à une étape ultérieure de la fabrication d'une extrémité de conducteurs multibrins entourés par une gaine résistive contenant dans les espaces entre les conducteurs et la gaine une poudre isolante.

Selon un mode particulier de realisation de l'invention les barreaux et la matrice métalliques sont de préférence utilisés pour réaliser des brins supraconducteurs à base de niobium-étain $Nb_3Sn$. Lesdits brins peuvent être aussi à base de composés tels que le niobium-silicum et le niobium-aluminium, le vanadium-gallium, le vanadium-silicium ou de composés à base de phases de CHEVREL tel le plomb-molybdène-soufre $PbMo_6S_8$. Dans le cas du niobium-étain, on part de barreaux de niobium disposés dans une matrice de bronze à base de cuivre et à au moins 10% en poids d'étain. Il est à noter que la diffusion de l'étain dans le niobium s'effectue à une température de 800°C environ à la fin des étapes et après l'embobinage des multibrins en un bobine, car les fils en alliage niobium-étain, une fois la diffusion effectuée, ont la propriété d'être cassants et de ne pas supporter sans dommage certaines manipulations tels l'enroulement des fils.

Dans une première étape de fabrication on met en place de barreaux de niobium dans une matrice de bronze.

Dans une deuxième étape on file et on étire les barreaux de niobium et la matrice de façon à obtenir des tiges de forme hexagonale permettant dans une troisième étape d'empliler les tiges multifilamentaires de forme hexagonale telles que 1 de la figure 1 les unes contre les autres avec, entre les hexagones, de la poudre 2 d'oxyde de magnésium MgO dopé de métal en alliage conducteur tel le bronze ou le cupronickel. La poudre peut être avantageusement précompactée.

On obtient ainsi des barrières résistives dont la caractéristique électrique est de nêtre ni trop conductrice ni trop résistive, afin de faire disparaître les courants induits parasites qui apparaissent dans le cuivre entre les filaments supraconducteurs et qui se dissipent en chaleur. La figure 2 illustre une variante d'un ensemble de tiges multifilamentaires 1 de forme hexagonale. A la fin de la troisième étape valable pour les figure 1 et 2 on revêt le paquet de tiges multifilamentaires 1 d'un tube de cuivre 4 qui sert à stabiliser le supraconducteur, c'est-à-dire qu'il permet dans le cas où le supraconducteur passe accidentellement à l'état normal de dériver le courant et d'empêcher le supraconducteur de brûler à cause de sa grande résistance; puis on enferme une poudre isolante électriquement 5 entre le tube de cuivre 4 et un couronne résistive 6 en cupronickel ou acier inoxydable. La poudre isolante 5 sert à isoler électriquement les brins 7 ou 7' les uns des autres puisque les brins 7 ou 7' sont embobinés dans un stade final, et risqueraient d'entrer en contact et de créer de ce fait des court-circuits. La poudre isolante 5 illustrée dans les figures 1 et 2 est de préférence de l'oxyde de magnésium MgO. Elle peut être également de l'oxyde d'aluminium $Al_2O_3$ ou du verre en poudre stable à 800°C ou dui quartz en poudre stable à 800°C également.

Au cours de la quatrième étape on exécute des étirages successifs, par exemple 30 fois, du brin représenté en figures 1 et 2 jusqu'à réduire la section de brin d'une centaine de fois, par exemple, en passant d'un diamètre de 50 millimètres à un diamètre de 0,5 millimètre, la couche d'oxyde 5 passant ainsi d'une épaisseur de 1 millimètre à une épaisseur de 10 microns.

Au cours de la cinquième étape le brin ainsi allongé et de section réduit est embobiné de façon à former une bobine d'électroaimant par exemple.

Au cours de la sixième étape on procède au traitement thermique par chauffage à 800°C pour réaliser in situ sur la bobine la diffusion des éléments métalliques.

La figure 3 illustre un produit plus élaboré que celui des figures 1 et 2, puisque les brins 7 ou 7', obtenus de la façon décrite précédemment dans les première, deuxième, troisième et quatrième étapes, sont mis en place, au cours d'une cinquième nouvelle étape, le nombre de brins 7 ou 7', étant par exemple de 7, à l'intérieur d'une gaine résistive 8 contenant une poudre isolante 9 identique à la poudre 5 définie précédemment. La gaine résistive peut être réalisée en cupronickel ou acier inoxydable.

La poudre isolante 9 peut être avantageusement précompactée dans un moule (par exemple sous une pression de quelques dizaines de kilogrammes par $mm^2$).

L'ensemble constitue un conducteur multibrins 10. Au cours d'une nouvelle sixième étape on procédé à au moins un étirage du conducteur multibrins 10 semblable à celui de la quatrième étape décrite précédemment.

Au cours d'une nouvelle septième étape le conducteur multibrins 10 une fois étiré est embobiné sur une bobine d'électroaimant par exemple.

Au cours d'une huitième étape on procède à un traitement thermique, par chauffage à environ 800°C, afin de réaliser la diffusion des éléments métalliques pour former la phase supraconductrice.

## Revendications

1. Procédé de fabrication de supraconducteurs comportant dans l'ordre les étapes de fabrication suivantes:

première étape — mis en place en barreaux d'une premier élément métallique dans une matrice métallique à au moins deux deuxièmes éléments, le premier élément et un deuxième élément devant former le supraconducteur,

deuxième étape — filage et étirage desdits barreaux afin d'obtenir des tiges (1) de forme extérieure hexagonale,

troisième étape — empilement des tiges (1) de forme hexagonale en un ensemble et revêtement de cet ensemble par un tube de bronze; la deuxième et la troisième étapes pouvant être répétées une ou deux fois; la dernière fois, ledit tube (4) pouvant être en cuivre et/ou certaines des tiges pouvant être remplacées par des tiges de cuivre servant à la stabilisation,

quatrième étape — filage et étirages multiples successifs de l'ensemble afin de réduire les sections et allonger les longueurs de cet ensemble pour réaliser un brin (7, 7') de faible diamètre,

cinquième étape — embobinage du brin en un bobine,

sixième étape — chauffage de la bobine à une température de 800°C environ pour réaliser la diffusion du premier élément métallique dans le deuxième élément, formant ainsi un composé intermétallique et supraconducteur, caractérisé en ce qu'à la fin de la troisième étape on dispose entre le tube (4) et une couronne résistive (6) une poudre isolante (5) électriquement, réfractaire et non soluble dans les tubes (4) et la couronne (6), et en ce qu'on cours de la troisième étape et au début de celle-ci, les tiges (1) de forme hexagonale peuvent être empilées les unes contre les autres en même temps qu'une poudre d'oxyde (2) dopé d'élément conducteur disposée entre les empilements et servant de barrières résistives.

2. Procédé de fabrication de suprconducteurs comportant dans l'ordre les étapes de fabrication suivantes:

première étape — mise en place en barreaux d'un premier élément métallique dans une matrice métallique à au moins deux deuxièmes éléments, le premier élément et un deuxième élément devant former le supraconducteur,

deuxième étape — filage et étirage des barreaux afin d'obtenir des tiges (1) de forme extérieure hexagonale,

troisième étape — empilement des tiges (1) de forme hexagonale en un ensemble et revêtement de cet ensemble par un tube (4) de cuivre, certaines des tiges pouvant être remplacées par des tiges de cuivre servant à la stabilisation,

quatrième étape — filage et étirages multiples successifs de l'ensemble afin de réduire les sections et allonger les longueurs de cet ensemble pour réaliser un brin de faible diamètre,

cinquième étape — enrobage des brins multifilamentaires par une gaine résistive (8) et mise en place d'une pluralité de brins (7, 7') afin de former un conducteur multibrins (10),

sixième étape — embobinage du conducteur multibrins en un bobine,

septième étape — chauffage de la bobine à une température de 800°C environ pour réaliser la diffusion du premier élément métallique dans le deuxième élément, formant ainsi une composé intermétallique et supraconducteur, caractérisé en ce qu'au cours de la cinquième étape on dispose entre les brins (7) et la gaine résistive (8) une poudre isolante (9) électriquement, réfractaire et non soluble dans ladite gaine résistive et les brins (7), et en ce qu'au cours de la troisième étape et au début de celle-ci, les tiges (1) de forme hexagonale peuvent être empilées les unes contre les autres en même temps qu'une poudre d'oxyde (2) dopé d'élément conducteur disposée entre les empilements et servant de barrières résistives.

3. Procédé selon les revendications 1 ou 2, caractérisé en ce que la poudre d'oxyde est de l'oxyde de magnésium MgO dopé de cuivre ou d'un alliage de cuivre tel que le bronze ou le cupro-nickel.

4. Procédé selon les revendications 1 ou 2, caractérisé en ce que la poudre isolante est de l'oxyde de magnesium MgO ou d'aluminium $Al_2O_3$.

5. Procédé selon les revendications 1 ou 2, caractérisé en ce que la poudre isolante est du verre stable à 800°C.

6. Procédé selon les revendications 1 ou 2, caractérisé en ce que la poudre isolante est du quartz stable à 800°C.

7. Procédé selon les revendications 1 à 6, caractérisé en ce que le composé intermétallique est du niobium-étain $Nb_3Sn$ et que ledit premier élément est du bronze et ledit deuxième élément du niobium.

8. Procédé selon les revendications 1 à 6, caractérisé en ce que la les composés intermétalliques font partie du groupe de composés formés par le niobium-silicium $Nb_3Si$, le niobium-aluminium $Nb_3Al$, le vanadium-gallium $V_3Ga$, le vanadium-silicium $V_3Si$.

9. Procédé selon les revendications 1 à 6, caractérisé en ce que les composés intermétalliques sont des supraconducteurs à base de phases de CHEVREL, de préférence le plomb-molybdénesoufre $PbMo_6S_8$.

10. Procédé selon les revendications 1 à 9, caractérisé en ce que les poudres d'oxyde dopè et isolante électriquement sont précompactées sous un charge de quelques dizaines de kilogrammes par millimètre carré.

**Patentansprüche**

1. Verfahren zur Herstellung von Supraleitern, das hintereinander die folgenden Herstellungsstufen aufweist:

erste Stufe — Anbringen eines ersten metallischen Elements in Form einer Bramme in einer metallischen Matrix aus mindestens zwei zweiten Elementen, wobei das erste Element und eine zweites Element den Supraleiter bilden sollen,

zweite Stufe — Spinnen und Ausziehen der Brammen, um Stäbe (1) einer hexagonalen äußeren Form zu erhalten,

dritte Stufe — Stapeln der Stäbe (1) hexagonaler Form in einer Einheit und Umhüllen dieser Einheit mit einem Bronzerohr, wobei die zweite und die dritte Stufe einmal oder zweimal wiederholt werden können und das letzte Mal das Rohr (4) aus Kupfer sein kann und/oder einige der Stäbe durch Kupferstäbe ersetzt werden können, was der Stabilisierung dient,

vierte Stufe — aufeinanderfolgendes Spinnen und vielfaches Ausziehen der Einheit, um die Querschnitte zu verringern und die Längen dieser Einheit zu vergrößern, um eine Litze (7, 7') geringen Durchmessers zu erhalten,

fünfte Stufe — Aufwickeln der Litze zu einer Spule,

sechste Stufe — Erhitzen der Spule auf eine Temperatur von etwa 800°C, um die Diffusion des ersten metallischen Elements im zweiten Element zu bewirken, wodurch eine intermetallische und supraleitende Verbindung gebildet wird, dadurch gekennzeichnet, daß am Ende der dritten Stufe zwischen das Rohr (4) und eine Widerstandskrone (6) ein elektrisch isolierendes Pulver (5) gebracht wird, das hitzebeständig und in den Rohren (4) und der Krone (6) nicht löslich ist, und daß während der dritten Stufe und an ihrem Anfang die Stäbe (1) hexagonaler Form unter Beigabe eines mit einem leitenden Element dotierten Oxidpulvers (2) gestapelt werden können, das zwischen den Stapeln angeordnet ist und als Widerstandsbarriere dient.

2. Verfahren zur Herstellung von Supraleitern, das hintereinander die folgenden Herstellungsstufen aufweist:

erste Stufe — Anbringen eines ersten metallischen Elements in Form einer Bramme in einer metallischen Matrix aus mindestens zwei zweiten Elementen, wobei das erste Element und ein zweites Element den Supraleiter bilden sollen,

zweite Stufe — Spinnen und Ausziehen der Brammen, um Stäbe (1) einer hexagonalen äußeren Form zur erhalten,

dritte Stufe — Stapeln der Stäbe (1) hexagonaler Form in einer Einheit und Umhüllen dieser Einheit mit einem Kupferrohr (4), wobei einige der Stäbe durch der Stabilisierung dienende Kupferstäbe ersetzt werden können,

vierte Stufe — aufeinanderfolgendes Spinnen und vielfaches Ausziehen der Einheit, um die Querschnitte zu verringern und die Längen dieser Einheit zu vergrößern, um eine Litze geringen Durchmessers zu erhalten,

fünfte Stufe — Umhüllen der vieldrähtigen Litzen mit einer Widerstandshülle (8) und Anbringen einer Vielzahl von Litzen (7, 7') zur Bildung eines Viellitzenleiters (10),

sechste Stufe — Aufwickeln des Viellitzenleiters zu einer Spule,

siebte Stufe — Erhitzen der Spule auf eine Temperatur von etwa 800°C, um die Diffusion des ersten metallischen Elements im zweiten Element zu bewirken, wodurch eine intermetallische und supraleitende Verbindung gebildet wird,

dadurch gekennzeichnet, daß während der fünften Stufe zwischen den Litzen (7) und der Widerstandshülle (8) ein elektrisch isolierendes Pulver (9) angebracht wird, das hitzebeständig und in der Widerstandshülle und den Litzen (7) nicht löslich ist, und daß während der dritten Stufe und an ihrem Anfang die Stäbe (1) hexagonaler Form unter Beigabe eines mit einem leitenden Element dotierten Oxidpulvers (2), das zwischen den Stapeln angeordnet ist und als Widerstandsbarriere dient, aneinander gestapelt werden können.

3. Verfahren nach den Ansprüchen 1 oder 2, dadurch gekennzeichnet, daß das Oxidpulver mit Kupfer oder einer Kupferlegierung wie Bronze oder Cupro-Nickel dotiertes Magnesiumoxid MgO ist.

4. Verfahren nach den Ansprüchen 1 oder 2, dadurch gekennzeichnet, daß das isolierende Pulver Magnesiumoxid MgO oder Aluminiumoxid $Al_2O_3$ ist.

5. Verfahren nach den Ansprüchen 1 oder 2, dadurch gekennzeichnet, daß das isolierende Pulver ein bei 800°C stabiles Glas ist.

6. Verfahren nach den Ansprüchen 1 oder 2, dadurch gekennzeichnet, daß das isolierende Pulver aus bei 800°C stabilem Quarz besteht.

7. Verfahren nach einem der Ansprüche 1 bis 6, dadurch gekennzeichnet, daß die intermetallische Verbindung Niobium-Zinn $Nb_3Sn$ ist und daß das erste Element Bronze und das zweite Element Niobium ist.

8. Verfahren nach den Ansprüchen 1 bis 6, dadurch gekennzeichnet, daß die intermetallischen Verbindungen zu der Gruppe von Verbindungen gehören, die aus Niobium-Silizium $Nb_3Si$, Niobium-Aluminium $Nb_3Al$, Vanadium-Gallium $V_3Ga$ und Vanadium-Silizium $V_3Si$ besteht.

9. Verfahren nach den Ansprüchen 1 bis 6, dadurch gekennzeichnet, daß die intermetallischen Verbindungen Supraleiter auf der Basis von CHEVREL-Phasen sind, vorzugsweise Blei-Molybdän-Schwefel $PbMo_6S_8$.

10. Verfahren nach den Ansprüchen 1 bis 9, dadurch gekennzeichnet, daß die dotierten und elektrisch isolierenden Oxidpulver unter einer Last von einigen zehn Kilogramm pro mm² vorgepreßt werden.

**Claims**

1. A method of manufacturing superconductors comprising the following steps:

first step — bars of a first metal material are placed in a metal matrix comprising at least two second materials, said first material and a second material constituting said superconductor,

second step — said bars are spun and drawn so as to form rods (1) having a hexagonal outside contour,

third step — said hexagonal rods (1) are stacked together and surrounded with a bronze tube, the second and third step being apt to be repeated once or twice; at the last repetition, said tube (4) being made of copper and/or certain of said rods being replaced by copper rods, in order to improve stabilisation,

fourth step — successive spinning and multiple drawing of the unit so as to reduce the sections and increase the lengths of this unit in order to realise a strand (7, 7') of small diameter,

fifth step — winding of the strand on a spool,

sixth step — heating of the spool to a temperature of about 800°C so that the first metal element diffuses into said second element, thus forming an intermetallic and superconductive compound, characterized in that at the end of the third step, there is disposed, between the tube (4) and a resistive crown (6), an electrically insulating refractory powder (5), which is not soluble in the tubes (4) and the crown (6), and that during the third step and at its beginning, the hexagonal rods (1) can be stacked against one another at the same time as an oxide powder (2) doped with a conductive element disposed between the stacks and serving as a resistive barrier.

2. A method of manufacturing superconductors comprising the following manufacturing steps:

first step — bars of a first metal material are placed in a metal matrix comprising at least two second materials, said first material and a second material constituting said superconductor,

second step — said bars are spun and drawn so as to form rods (1) having a hexagonal outside contour,

third step — said hexagonal rods (1) are stacked together and surrounded with a bronze tube (4), certain of these rods being apt to be replaced by copper rods in order to improve stabilization,

fourth step — successive spinning and multiple drawing of the unit so as to reduce the sections and increase the lengths of this unit in order to realise a strand of small diameter,

fifth step — coating of the multi-wire strands with a resistive sheath (8) and placing of a plurality of strands (7, 7') in order to form a multistrand conductor (10),

sixth step — winding of the multistrand conductor on a spool,

seventh step — heating of the spool to a temperature of about 800°C so that the first metal element diffuses into said second element, thus forming an intermetallic and superconductive compound, characterized in that during the fifth step, there is disposed between the strands (7) and the resistive sheath (8) an electrically insulating powder (9) which is refractory and not soluble in said resistive sheath and the strands (7), and that during the third step and its beginning, the rods (1) of hexagonal form can be stacked against each other at the same time as an oxide powder (2) doped with a conductive element disposed between the stacks and serving as resistive barriers.

3. A method according to claims 1 or 2, characterized in that the oxide powder is magnesium oxide MgO doped with copper or a copper alloy such as bronze or cupro-nickel.

4. A method according to claims 1 and 2, characterized in that the insulating powder is magnesium oxide MgO or aluminum oxide $Al_2O_3$.

5. A method according to claims 1 or 2, characterized in that the insulating powder is a glass which is stable at 800°C.

6. A method according to claims 1 or 2, characterized in that the insulating powder is a quartz which is stable at 800°C.

7. A method according to claims 1 to 6, characterized in that the intermetallic compound is niobium-tin $Nb_3Sn$ and in that said first material is bronze and said second material is niobium.

8. A method according to claim 1 to 6, characterized in that the intermetallic compounds are part of the group formed by niobium-silicon $Nb_3Si$, niobium-aluminum $Nb_3Al$, vanadium-gallium $V_3Ga$, vanadium-silicon $V_3Si$.

9. A method according to claims 1 to 6, characterized in that the intermetallic compounds are superconductors on the basis of CHEVREL phases, preferably lead-molybdenum-sulfur $PbMo_6S_8$.

10. A method according to claims 1 to 9, characterized in that the electrically insulating and doped oxide powders are precompacted with a pressure of some ten kilograms per square millimeter.

# FIG.1

## FIG. 2

## FIG. 3